# EUROPEAN PATENT APPLICATION

(11) **EP 4 425 546 A1**
(43) Date of publication of application: **04.09.2024**
(21) Application number: 22886672.9
(22) Date of filing: 11.10.2022
(51) Int. Cl.: H01L 25/04, H01L 25/18

(54) **SUBSTRATE FOR MOUNTING ELECTRONIC ELEMENTS, ELECTRONIC DEVICE, AND ELECTRONIC MODULE**

(30) Priority: 25.10.2021 JP 2021174038
(71) Applicant: Kyocera Corporation, Kyoto-shi Kyoto 612-8501 (JP)
(72) Inventor: SUZUKI, Yuki, Kyoto-shi, Kyoto 612-8501 (JP)
(74) Representative: Viering, Jentschura & Partner mbB Patent- und Rechtsanwälte
(86) International application number: PCT/JP2022/037801
(87) International publication number: WO 2023/074342

(57) **Abstract**

An electronic element mounting substrate includes a base having a first element mounting region for mounting a light receiving element serving as a first electronic element and a second element mounting region for mounting a light emitting element serving as a second electronic element. The first element mounting region and the second element mounting region have different heights in a cross-sectional view.

## Description

### TECHNICAL FIELD

The present disclosure relates to an electronic element mounting substrate, an electronic device, and an electronic module.

### BACKGROUND OF INVENTION

Conventionally, as described in Patent Document 1, there has been known an electronic device (referred to as an optical device in Patent Document 1) in which a light receiving element serving as a first electronic element and a light emitting element (referred to as a light emitting element array in Patent Document 1) serving as a second electronic element are mounted on an upper surface of a base (referred to as a substrate in Patent Document 1) made of an electrical insulation material, for example.

### CITATION LIST

### PATENT LITERATURE

Patent Document 1: JP 2020-155622 A

### SUMMARY

An electronic element mounting substrate according to the present disclosure includes a base having a first element mounting region for mounting a first electronic element and a second element mounting region for mounting a second electronic element. The first element mounting region and the second element mounting region have different heights in a cross-sectional view.

An electronic device according to the present disclosure includes the electronic element mounting substrate, the first electronic element mounted in the first element mounting region, and the second electronic element mounted in the second element mounting region.

An electronic module according to the present disclosure includes the electronic device and a casing located on an upper surface of a base of the electronic device.

### BRIEF DESCRIPTION OF THE DRAWINGS

FIG. 1 is a schematic plan view illustrating an electronic device according to a first embodiment.
FIG. 2 is a schematic cross-sectional view taken along a line I-II in FIG. 1.
FIG. 3 is a schematic plan cross-sectional view illustrating an electronic module according to the first embodiment.
FIG. 4 is a schematic cross-sectional view taken along a line IV-IV in FIG. 3.
FIG. 5 is a schematic plan view illustrating another aspect of the electronic device according to the first embodiment.
FIG. 6 is a schematic cross-sectional view taken along a line VI-VI in FIG. 5.
FIG. 7 is a schematic plan view illustrating another aspect of the electronic device according to the first embodiment.
FIG. 8 is a schematic cross-sectional view illustrating another aspect of the electronic device according to the first embodiment.
FIG. 9 is a schematic cross-sectional view illustrating another aspect of the electronic device according to the first embodiment.
FIG. 10 is a schematic plan view illustrating another aspect of the electronic device according to the first embodiment.
FIG. 11 is a schematic cross-sectional view taken along a line XI-XI in FIG. 10.
FIG. 12 is a schematic plan view illustrating another aspect of the electronic module according to the first embodiment.
FIG. 13 is a schematic cross-sectional view taken along a line XIII-XIII in FIG. 12.
FIG. 14 is a schematic plan view illustrating another aspect of the electronic module according to the first embodiment.
FIG. 15 is a schematic cross-sectional view taken along a line XV-XV in FIG. 14.
FIG. 16 is a schematic plan view illustrating another aspect of the electronic module according to the first embodiment.
FIG. 17 is a schematic cross-sectional view taken along a line XVII-XVII in FIG. 16.
FIG. 18 is a schematic plan view illustrating an electronic device according to a second embodiment.
FIG. 19 is a schematic cross-sectional view taken along a line XIX-XIX in FIG. 18.
FIG. 20 is a schematic plan view illustrating an electronic device according to a third embodiment.
FIG. 21 is a schematic cross-sectional view taken along a line XXI-XXI in FIG. 20.
FIG. 22 is a schematic plan cross-sectional view illustrating an electronic device according to another aspect of a fourth embodiment.
FIG. 23 is a schematic cross-sectional view taken along a line XXIII-XXIII in FIG. 22.

### DESCRIPTION OF EMBODIMENTS

When heat generated from a light emitting element propagates to a light receiving element side, failure such as noise generation or a malfunction of the light receiving element may occur due to the heat. In other words, failure may occur in an electronic device due to the heat generated from the light emitting element. Thus, heat propagating from an electronic element generating heat to another electronic element is desired to be reduced.

An electronic element mounting substrate of the present disclosure, and an electronic device and an electronic module each including the substrate can reduce the likelihood of occurrence of failure due to the heat generated in the electronic element.

Hereinafter, the electronic element mounting substrate, the electronic device, and the electronic module according to embodiments will be described below in detail with reference to the drawings. However, each of the figures, which will be referred to below, is a simplified representation of only components necessary for description of the embodiments, for convenience of description. Accordingly, the electronic element mounting substrate, the electronic device, and the electronic module according to the embodiments may be provided with an optional component that is not illustrated in the referenced drawings. The dimensions of the components in the drawings may not faithfully represent the actual dimensions of the components, the dimension ratios of the members, or the like. Directions of the electronic element mounting substrate, the electronic device, and the electronic module are defined using an orthogonal coordinate system XYZ for convenience. A positive side in an X axis direction is referred to as a right side, a positive side in a Y axis direction is referred to as a front side, and a positive side in a Z axis direction is referred to as an upper side. In the present disclosure, an annular shape includes a rectangular annular shape, a circular annular shape, and an elliptical annular shape. A description "parallel" only needs to be parallel at a visible level and does not need to be strictly parallel.

### Electronic Element Mounting Substrate and Electronic Device According to First Embodiment

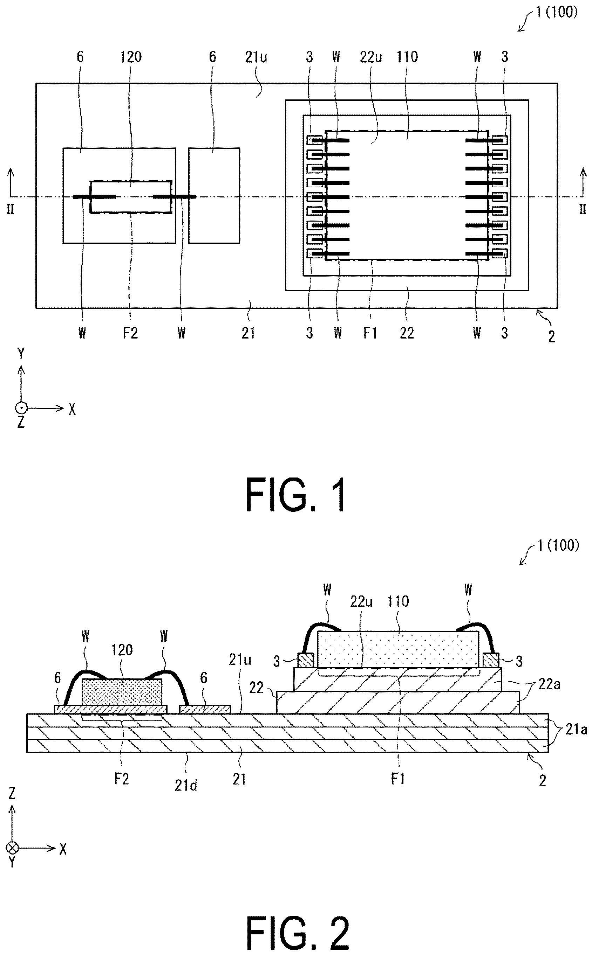

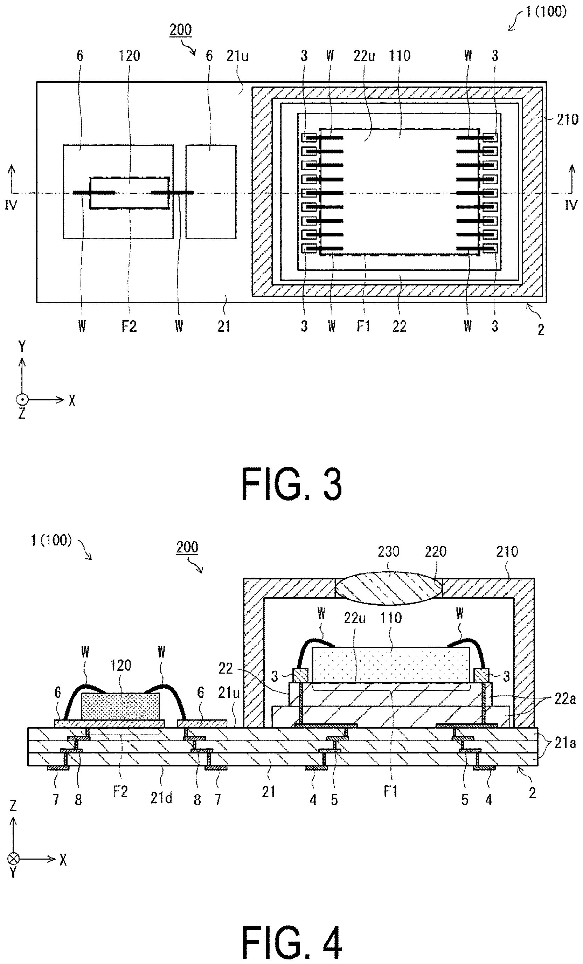

An electronic element mounting substrate 1 and an electronic device 100 according to a first embodiment will be described with reference to FIGs. 1 to 4. FIG. 1 is a schematic plan view illustrating an electronic device 100 according to the first embodiment. FIG. 2 is a schematic cross-sectional view taken along a line II-II in FIG. 1. FIG. 3 is a schematic plan cross-sectional view illustrating an electronic module 200 according to the first embodiment. FIG. 4 is a schematic cross-sectional view taken along a line IV-IV in FIG. 3.

As in the examples illustrated in FIGs. 1 to 4, the electronic device 100 according to the first embodiment includes the electronic element mounting substrate 1, a light receiving element 110 serving as a first electronic element mounted on the electronic element mounting substrate 1, and a light emitting element 120 serving as a second electronic element mounted on the electronic element mounting substrate 1. The electronic element mounting substrate 1 includes a base 2, and a plan view shape of the base 2 is, for example, a rectangular shape. The base 2 is made of, for example, an insulation ceramic such as an aluminum oxide-based sintered body (alumina ceramic), an aluminum nitride-based sintered body, a mullite-based sintered body, or a glass ceramic sintered body. A longitudinal direction of the base 2 may be a left-right direction (X axis direction), and a lateral direction of the base 2 may be a front-rear direction (Y axis direction).

Since the base 2 is made of an insulation ceramic, the base 2 has high heat dissipation and high rigidity. Even when the base 2 is formed in a deformed shape or a through hole is provided in the base 2, dust or the like is hardly generated. Even when the base 2 is heated by heat generation in the light emitting element 120, moisture, gas, and the like are hardly generated. Furthermore, a difference between a thermal expansion coefficient of silicon constituting the light receiving element 110 and the light emitting element 120 and a thermal expansion coefficient of the insulation ceramic is smaller than a difference between a thermal expansion coefficient of an organic material and the thermal expansion coefficient of the insulation ceramic. Thus, as compared with a case where the base 2 is made of an organic material, the base 2 made of the insulation ceramic can reduce a stress applied to the electronic element even when the heat generation in the light emitting element 120 occurs.

The base 2 may include a base portion 21, and a plan view shape of the base portion 21 is, for example, a rectangular shape. The base portion 21 has an upper surface 21u and a lower surface 21d. The base portion 21 may include three insulation layers 21a that have been layered on each other. The base portion 21 may include a plurality of the insulation layers 21a other than the three insulation layers 21a or one insulation layer 21a that have been layered on each other.

The base 2 may include a first pedestal 22 located at a right portion of the upper surface 21u of the base portion 21. The first pedestal 22 is integrated with the base portion 21 and has a first upper surface 22u. The first pedestal 22 may include two insulation layers 22a that have been layered on each other. A plurality of the insulation layers 22a may have a stepped shape in a cross-sectional view. The first pedestal 22 may include a plurality of the insulation layers 22a other than the laminated two insulation layers 22a or one insulation layer 22a.

A first element mounting region F1 for mounting the light receiving element 110 serving as the first electronic element may be located on an upper surface of the upper insulation layer 22a which is the first upper surface 22u of the first pedestal 22. In other words, the first upper surface 22u of the first pedestal 22 includes the first element mounting region F1. In still other words, the base 2 may have the first element mounting region F1 on the first upper surface 22u of the first pedestal 22. The first element mounting region F1 may be a region overlapping the light receiving element 110 in a plan view. The first element mounting region F1 may be a region surrounded by a virtual line connecting alignment marks used when mounting the light receiving element 110. The first element mounting region F1 may be a region where a metalized layer for mounting the light receiving element 110 is located.

A second element mounting region F2 for mounting the light emitting element 120 serving as the second electronic element may be located on the left side of the first pedestal 22 on the upper surface 21u of the base portion 21. In other words, the upper surface 21u of the base portion 21 may include the second element mounting region F2. In still other words, the base 2 may have the second element mounting region F2 on the left side of the first pedestal 22 on the upper surface of the base portion 21. The second element mounting region F2 may be a region overlapping the light emitting element 120 in a plan view. The second element mounting region F2 may be a region surrounded by a virtual line connecting alignment marks used when mounting the light emitting element 120. The second element mounting region F2 may be a region where a metalized layer for mounting the light emitting element 120 is located.

The first element mounting region F1 and the second element mounting region F2 are parallel to each other and have different heights in a cross-sectional view. Since the first element mounting region F1 and the second element mounting region F2 are parallel to each other in a cross-sectional view, mounting processes of the light receiving element 110 and the light emitting element 120 are simplified, and the light receiving element 110 and the light emitting element 120 can be mounted using the same manufacturing apparatus. Since the mounting surfaces are parallel to each other, the likelihood that the light receiving element 110 and the light emitting element 120 come off or shift from the upper surface of the base 2 in a case where the electronic device 100 is used for a long period of time or the like can be reduced. Heat generated by the heat generation in the electronic element is easily transferred uniformly from the upper surface of the base 2 to immediately below the base 2. A difference in thermal propagation amount (thermal distribution) between the inside of the first element mounting region F 1 and the inside of the second element mounting region F2 can be reduced, and temperature control is easy. Light emitted from the light emitting element 120 side is reflected and can be directly received at the light receiving element 110 side.

The first element mounting region F1 may be higher than the second element mounting region F2 by a thickness of the first pedestal 22 in a cross-sectional view. An arrangement direction that is a direction in which the first element mounting region F1 and the second element mounting region F2 are arranged may be the longitudinal direction (X axis direction) of the base 2. A direction orthogonal to the arrangement direction of the first element mounting region F1 and the second element mounting region F2 may be the lateral direction (Y axis direction) of the base 2. The arrangement direction is not limited to the X axis direction of the base 2 depending on the plan view shapes of the base 2, the first element mounting region F1, and the second element mounting region F2. The arrangement direction may be, for example, a direction along a line connecting a center of the first element mounting region F1 and a center of the second element mounting region F2.

A plurality of first connection pads 3 may be provided outside the first element mounting region F1 on the first upper surface 22u of the first pedestal 22. Each of the plurality of first connection pads 3 may be connected to a corresponding one of electrodes of the light receiving element 110 serving as the first electronic element by a wire W. In other words, each of the plurality of first connection pads 3 may be connected to a corresponding one of the electrodes of the light receiving element 110 by a wire bonding method. Alternatively, each of the plurality of first connection pads 3 may be connected to a corresponding one of the electrodes of the light receiving element 110 by a flip-chip bonding method.

A plurality of first external electrodes 4 may be provided on the lower surface 21d or the side surface of the base portion 21. Each of the plurality of first external electrodes 4 may be electrically connected to a corresponding one of first electrodes of an external substrate. A plurality of first wiring conductors 5 may be provided inside the base 2, and each of the plurality of first wiring conductors 5 may electrically connect a respective one of the plurality of first connection pads 3 to a corresponding one of the first external electrodes 4. Each of the plurality of first wiring conductors 5 may include a through conductor penetrating through the insulation layer 21a, a through conductor penetrating through the insulation layer 22a, and internal wiring.

Two second connection pads 6 may be provided on the upper surface 21u of the base portion 21. One of the second connection pads 6 may be located in a region including the second element mounting region F2 on the upper surface 21u of the base portion 21, and may function as a mounting pad for mounting the light emitting element 120 serving as the second electronic element. The other second connection pad 6 may be located outside the second element mounting region F2 on the upper surface 21u of the base portion 21. Each of the two second connection pads 6 may be connected to a corresponding one of electrodes of the light emitting element 120 serving as the second electronic element by the wire W. In other words, each of the two second connection pads 6 may be connected to a corresponding one of the electrodes of the light emitting element 120 by the wire bonding method. Each of the second connection pads 6 may be connected to a corresponding one of the electrodes of the light emitting element 120 by the flip-chip bonding method.

Two second external electrodes 7 may be provided on the lower surface 21d or the side surface of the base portion 21. Each of the two second external electrodes 7 may be electrically connected to a corresponding one of second electrodes of an external substrate. Two second wiring conductors 8 may be provided inside the base 2, and each of the two second wiring conductors 8 may electrically connect a respective one of the two second connection pads 6 to a corresponding one of the second external electrodes 7. Each of the plurality of second wiring conductors 8 may include a through conductor penetrating through the insulation layer 21a and may include internal wiring.

The first connection pad 3, the first external electrode 4, the first wiring conductor 5, the second connection pad 6, the second external electrode 7, and the second wiring conductor 8 are made of metalized metal powder containing, for example, tungsten (W), molybdenum (Mo), manganese (Mn), silver (Ag), or copper (Cu), as a component.

As in the example illustrated in FIGs. 1 and 2, when the base 2 is made of, for example, an aluminum oxide-based sintered body, the base 2 is produced in the following manner. An appropriate organic binder, a solvent and the like are added to and mixed with a raw material powder of aluminum oxide, silicon oxide or the like to produce a slurry. A ceramic green sheet for the insulation layers 21a and 22a is produced by forming the slurry into a sheet shape by a doctor blade method, a calender roll method, or the like. Thereafter, a plurality of the ceramic green sheets for the insulation layers 21a and 22a are layered on each other to produce a laminate body for the base 2. The laminate body for the base 2 is fired at a high temperature (from about 1300°C to about 1600°C) to produce the base 2.

The first connection pad 3, the first external electrode 4, the first wiring conductor 5, the second connection pad 6, the second external electrode 7, and the second wiring conductor 8 can be formed as below when they are, for example, metalized layers of tungsten. Internal wiring of the first connection pad 3, the first external electrode 4, and the first wiring conductor 5, and internal wiring of the second connection pad 6, the second external electrode 7, and the second wiring conductor 8 can be formed as below. The internal wiring is formed by printing a metal paste produced by mixing powder of tungsten with an organic solvent and an organic binder at a predetermined position on the ceramic green sheet for the insulation layers 21a and 22a by a method such as a screen printing method, and then firing the laminate body for the base 2. The through conductor of the first wiring conductor 5 and the through conductor of the second wiring conductor 8 are formed by providing a hole for the through conductor at a predetermined position on the ceramic green sheet for the insulation layers 21a and 22a and filling the hole for the through conductor with a metal paste.

A nickel plating layer/gold plating layer as a metal plating layer may be deposited on externally exposed surfaces of the first connection pad 3, the first external electrode 4, the first wiring conductor 5, the second connection pad 6, the second external electrode 7, and the second wiring conductor 8 by a plating method. The plating method is, for example, an electroplating method or an electroless plating method. Consequently, corrosion of the first wiring conductor 5, the second wiring conductor 8, and the like can be effectively reduced. The metal plating layer is not limited to the nickel plating layer/gold plating layer, and may be another metal plating layer including a nickel plating layer/palladium plating layer/gold plating layer, or the like.

As in the example illustrated in FIGs. 1 and 2, according to the configuration of the electronic element mounting substrate 1 according to the first embodiment, the first element mounting region F 1 and the second element mounting region F2 are located at different heights in a cross-sectional view. In particular, when the first upper surface 22u of the first pedestal 22 includes the first element mounting region F1 and the upper surface of the base portion 21 includes the second element mounting region F2, the first element mounting region F1 and the second element mounting region F2 are located at different heights separated by the height of the first pedestal 22 in a cross-sectional view. Consequently, the distance between the first element mounting region F1 and the second element mounting region F2 can be increased. In addition, since the distance from the second element mounting region F2 serving as the heat generating portion to a lower surface of the base 2 in contact with the outside is shorter than the distance from the first element mounting region F1 to the lower surface, heat from the heat generating portion easily propagates from the lower surface of the base 2 to the outside. Thus, the heat generated in the light emitting element 120 serving as the second electronic element hardly propagates to the light receiving element 110 side, the light receiving element 110 serving as the first electronic element. Thus, the likelihood of occurrence of failure of the light receiving element 110 due to the heat generated in the light emitting element 120 can be reduced. In addition, by setting the first element mounting region F1 higher in a cross-sectional view to secure the distance between the first element mounting region F1 and the second element mounting region F2, the distance between the first element mounting region F1 and the second element mounting region F1 can be shortened in a plan view. That is, the electronic device 100 can be reduced in size.

When the first pedestal 22 includes a plurality of insulation layers 22a that have been layered on each other, a large difference in height between the first element mounting region F1 and the second element mounting region F2 in a cross-sectional view can be easily provided by the plurality of insulation layers 22a. In addition, the height of the first pedestal 22 can be easily adjusted. Thus, the heat generated in the light emitting element 120 further hardly propagates to the light receiving element 110 side. Consequently, the likelihood of occurrence of failure of the light receiving element 110 due to the heat generated in the light emitting element 120 can be further reduced.

When the plurality of insulation layers 22a have the stepped shape in a cross-sectional view, an installation position of the first connection pad 3 can be adjusted. An electronic component such as a capacitor can be installed on the upper surface of the insulation layer 22a on the lower layer side in addition to the upper surface of the uppermost insulation layer 22a which is the first upper surface 22u of the first pedestal 22. In addition, since the first connection pad 3 and the electronic component such as a capacitor can be installed at positions close to each other, electrical characteristics of the electronic device 100 are improved.

As in the example illustrated in FIGs. 1 and 2, the electronic device 100 includes the electronic element mounting substrate 1, the light receiving element 110 serving as the first electronic element mounted in the first element mounting region F1 of the base 2, and the light emitting element 120 serving as the second electronic element mounted in the second element mounting region F2 of the base 2. A first electronic element other than the light receiving element 110 may be mounted in the first element mounting region F1 of the base 2. A second electronic element other than the light emitting element 120 may be mounted in the second element mounting region F2 of the base 2.

The light receiving element 110 is, for example, a photodiode, and may be bonded to the first element mounting region F1 of the base 2 with an adhesive. Each of the plurality of electrodes of the light receiving element 110 may be connected to a corresponding one of the first connection pads 3 by the wire bonding method or the flip-chip bonding method. The light emitting element 120 is, for example, a laser diode such as a light emitting diode (LED) or a vertical cavity surface emitting laser (VCSEL) type, and may be bonded to the second element mounting region F2 of the base 2 by one of the second connection pads 6. Each of the two electrodes of the light emitting element 120 may be connected to a corresponding one of the second connection pads 6 by the wire bonding method or the flip-chip bonding method.

As in the example illustrated in FIGs. 1 and 2, since the electronic device 100 includes the electronic element mounting substrate 1, the likelihood of occurrence of failure such as noise generation or a malfunction of the light receiving element 110 due to propagation of the heat generated in the light emitting element 120 to the light receiving element 110 side can be further reduced.

As in the example illustrated in FIGs. 3 and 4, the electronic module 200 according to the first embodiment includes the electronic device 100 and a casing 210 located on the upper surface 21u of the base portion 21 of the base 2 in the electronic device 100. The casing 210 is made of, for example, a metal such as aluminum (Al) or a resin such as polybutylene terephthalate (PBT). The casing 210 may be bonded to the upper surface 21u of the base portion 21 of the base 2 by a bonding material such as a brazing material or an adhesive. The casing 210 may cover an upper side of the first element mounting region F1 of the base 2. The casing 210 may cover an upper side of the second element mounting region F2 of the base 2 instead of covering the upper side of the first element mounting region F1 of the base 2.

The casing 210 may include a holding hole 220 in an upper portion of the casing 210, and the holding hole 220 penetrates through the upper portion of the casing 210. A lens 230 may be provided in the holding hole 220 of the casing 210, and the lens 230 may have a function of focusing external light incident from the outside on a light receiving surface of the light receiving element 110. An IR cut filter blocking infrared rays may be provided on a light emission side of the lens 230.

As in the example illustrated in FIGs. 3 and 4, since the electronic module 200 includes the electronic device 1, the likelihood of occurrence of failure such as noise generation or a malfunction of the light receiving element 110 due to propagation of the heat generated in the light emitting element 120 to the light receiving element 110 side can be further reduced.

### Electronic Element Mounting Substrate and Electronic Device According to Another Aspect of First Embodiment

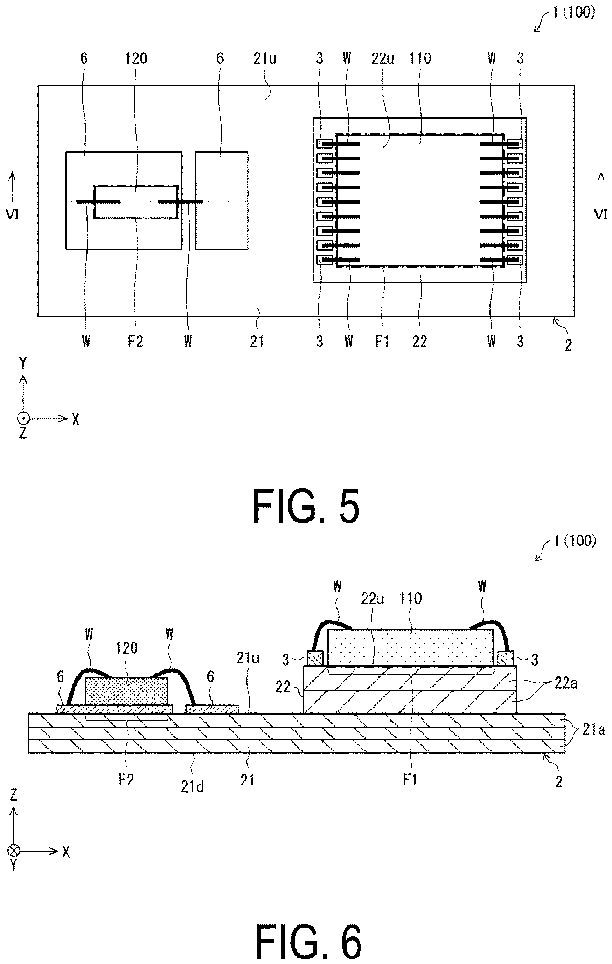

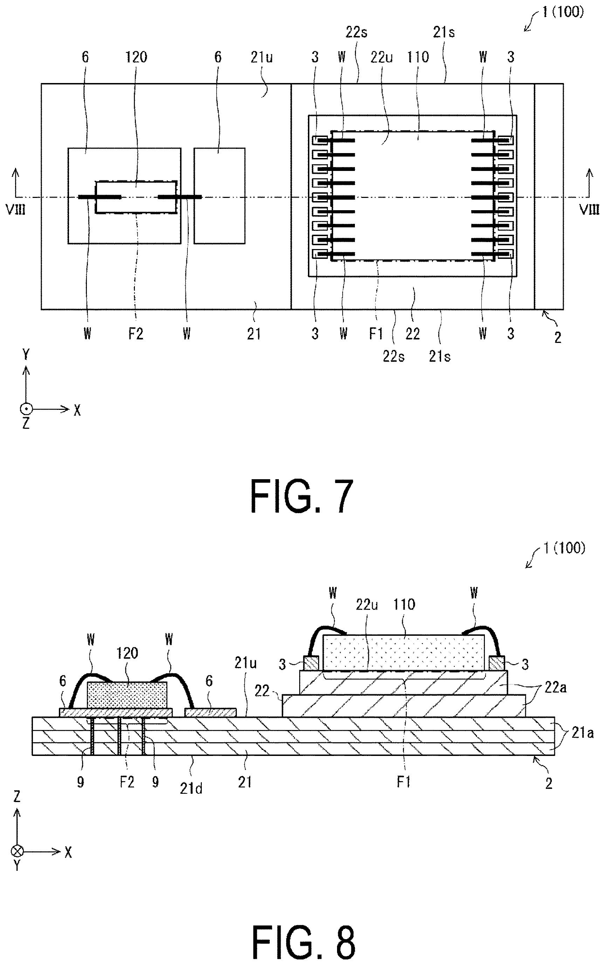

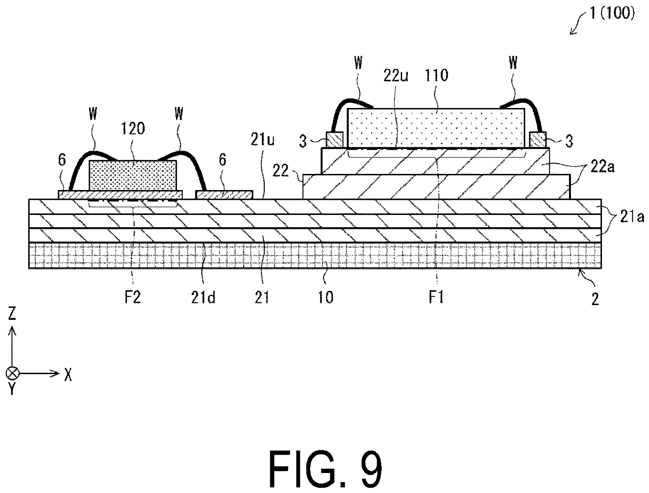

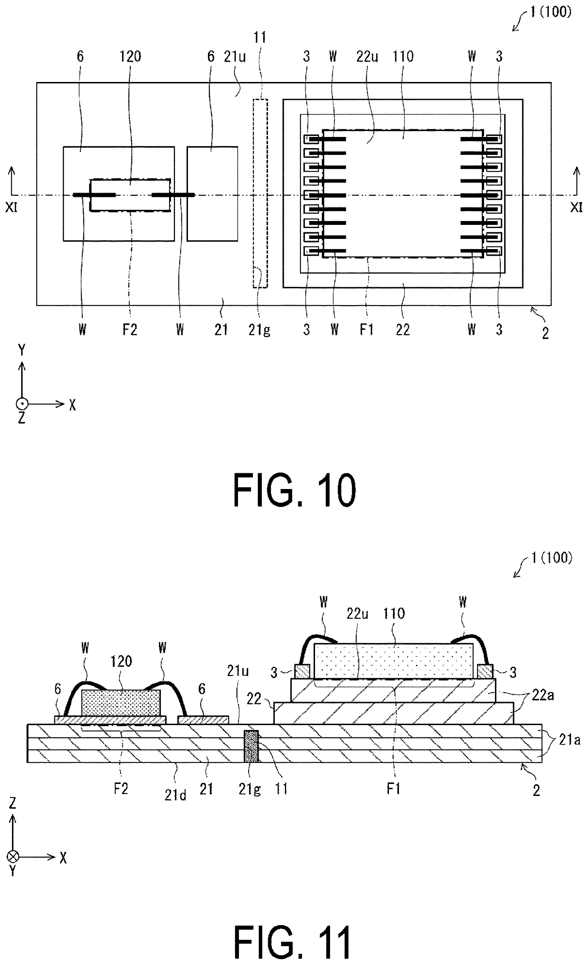

A configuration of the electronic element mounting substrate 1 and the electronic device 100 according to another aspect of the first embodiment will be described with reference to FIGs. 5 to 11. FIG. 5 is a schematic plan view illustrating another aspect of the electronic device 100 according to the first embodiment. FIG. 6 is a schematic cross-sectional view taken along a line VI-VI in FIG. 5. FIG. 7 is a schematic plan view illustrating another aspect of the electronic device 100 according to the first embodiment. FIG. 8 is a schematic cross-sectional view illustrating another aspect of the electronic device 100 according to the first embodiment. FIG. 9 is a schematic cross-sectional view illustrating another aspect of the electronic device 100 according to the first embodiment. FIG. 10 is a schematic plan view illustrating another aspect of the electronic device 100 according to the first embodiment. FIG. 11 is a schematic cross-sectional view taken along a line XI-XI in FIG. 10.

As in the example illustrated in FIGs. 5 and 6, the side surfaces of the plurality of insulation layers 22a may be flush with each other in a plan view. In this case, size and weight reduction of the base 2, in other words, size and weight reduction of the electronic element mounting substrate 1 can be achieved. That is, in the contents of the present disclosure, by lengthening a propagation path in the thickness direction instead of lengthening a propagation path between the light emitting element 120 and the light receiving element 110 in the planar direction in order to reduce the propagation of heat, a reduction in the size of the electronic element mounting substrate 1 can be achieved. Making the side surfaces of the insulation layers 22a be flush with each other in a plan view is advantageous for further reducing the size of the electronic element mounting substrate 1.

As in the example illustrated in FIG. 7, two first side surfaces 22s of the first pedestal 22 parallel to the left-right direction (X axis direction) which is the arrangement direction of the first element mounting region F1 and the second element mounting region F2 may be flush with two third side surfaces 21s of the base portion 21 parallel to the left-right direction in a plan view. In this case, the first upper surface 22u of the first pedestal 22 expands in the front-rear direction (Y axis direction). Consequently, a space for installing the casing 210 on the first pedestal 22 can be secured. In addition, for example, the electronic component such as a capacitor can be installed at the same height as the light receiving element 110 serving as the first electronic element, and the electrical characteristics of the electronic device 100 are improved.

As in the example illustrated in FIG. 8, the electronic element mounting substrate 1 may include a plurality of thermal vias 9, each of the thermal vias 9 penetrating along the thickness direction of the base 2 at a position overlapping the light emitting element 120 when viewed from directly above. Each of the plurality of thermal vias 9 may be connected to the second element mounting region F2.

The thermal via 9 is made of, for example, metalized metal powder containing tungsten (W), molybdenum (Mo), manganese (Mn), silver (Ag), or copper (Cu) as a component. The thermal via 9 is formed by providing a hole for the thermal via at a predetermined position of the ceramic green sheet for the insulation layers 21a and 22a and filling the hole for the thermal via with a metal paste.

When the electronic element mounting substrate 1 includes the plurality of thermal vias 9, the heat generated in the light emitting element 120 propagates to the lower surface of the base 2. Consequently, the likelihood of occurrence of failure of the light receiving element 110 due to heat generated in the light emitting element 120 can be further reduced.

As in the example illustrated in FIG. 9, the electronic element mounting substrate 1 may include a heat sink 10 located on the lower surface 21d of the base portion 21 which is the lower surface of the base 2 and dissipating the heat generated from the light emitting element 120. The heat sink 10 may be bonded to the lower surface 21d of the base portion 21 by a bonding material such as a resin adhesive. The heat sink 10 may be made of a metal having high thermal conductivity, such as aluminum.

When the electronic element mounting substrate 1 includes the heat sink 10, the heat generated in the light emitting element 120 is dissipated by the heat sink 10. Consequently, the likelihood of occurrence of failure of the light receiving element 110 due to the heat generated in the light emitting element 120 can be further reduced.

As in the example illustrated in FIGs. 10 and 11, a groove 21g extending in the lateral direction (Y axis direction) of the base 2 may be located between the first element mounting region F1 and the second element mounting region F2 on the lower surface 21d of the base portion 21. A heat shielding portion 11 having a thermal conductivity lower than that of the base 2 may be located in the groove 21g of the base portion 21. In other words, the heat shielding portion 11 extending in the lateral direction of the base 2 may be located between the first element mounting region F1 and the second element mounting region F2 in the base 2. The heat shielding portion 11 is made of, for example, a thermosetting resin or a thermoplastic resin.

The groove 21g of the base portion 21 is formed by performing appropriate punching processing on the ceramic green sheet for the insulation layer before firing the laminate body for the base 2.

When the electronic element mounting substrate 1 includes the heat shielding portion 11, the heat generated in the light emitting element 120 further hardly propagates to the light receiving element 110 side. Consequently, the likelihood of occurrence of failure of the light receiving element 110 due to the heat generated in the light emitting element 120 can be further reduced.

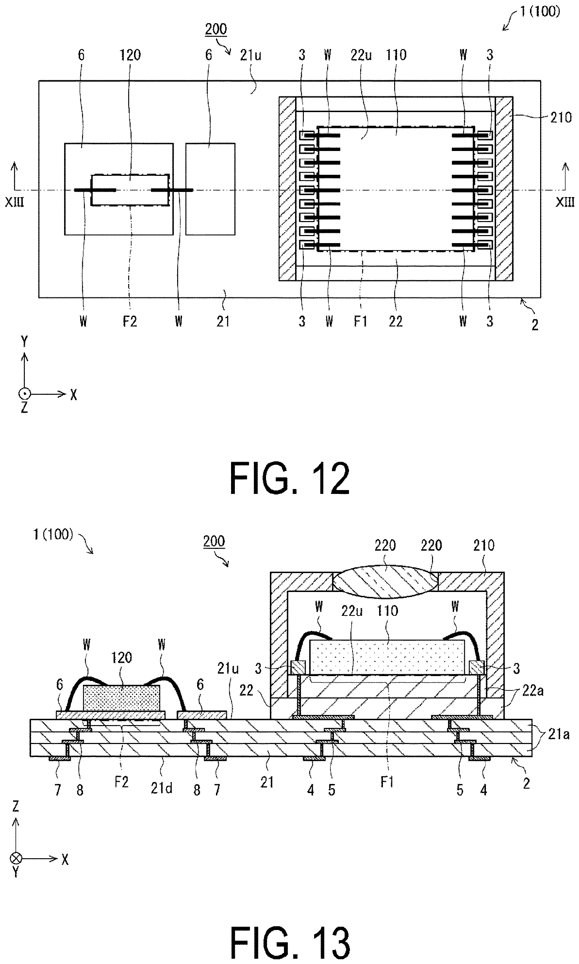

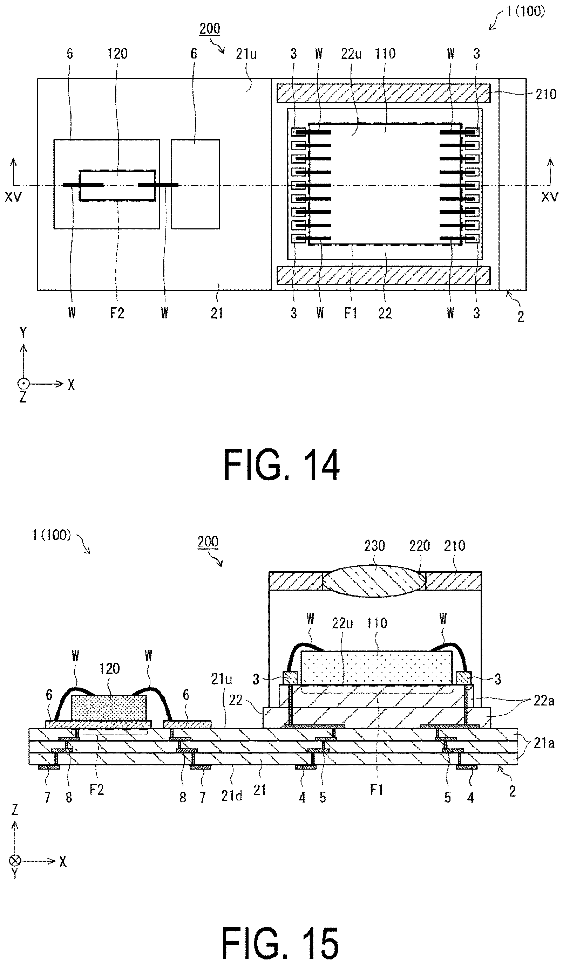

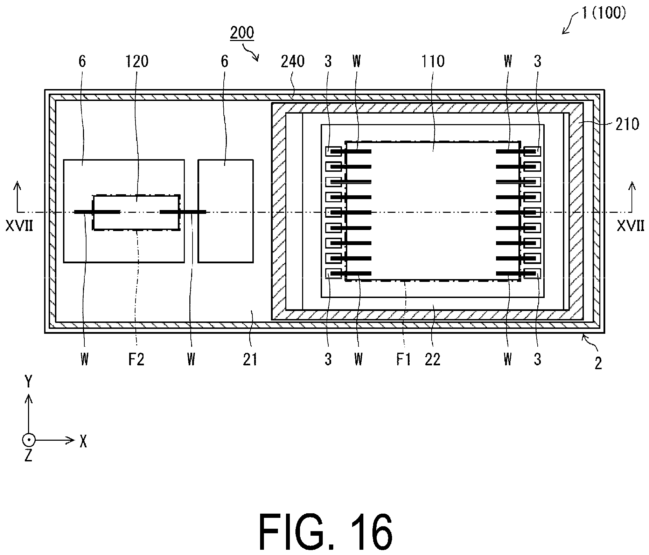

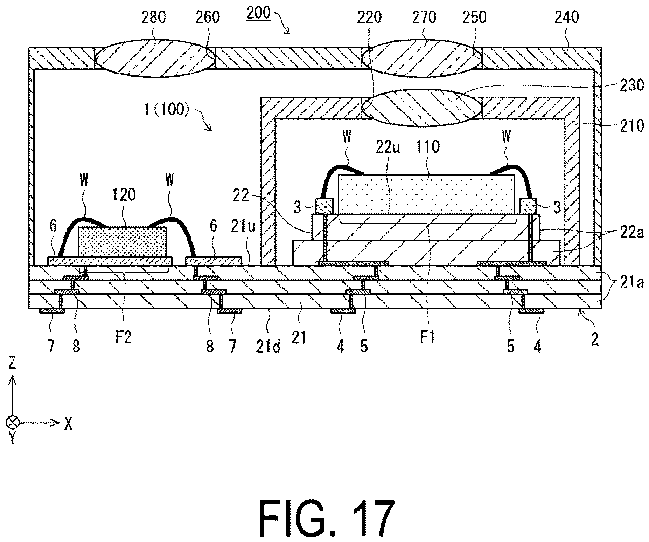

Electronic Module according to Another Aspect of First Embodiment The electronic module 200 according to a variation of the first embodiment will be described with reference to FIGs. 12 to 17. FIG. 12 is a schematic plan view illustrating another aspect of the electronic module 200 according to the first embodiment. FIG. 13 is a schematic cross-sectional view taken along a line XIII-XIII in FIG. 12. FIG. 14 is a schematic plan view illustrating another aspect of the electronic module 200 according to the first embodiment. FIG. 15 is a schematic cross-sectional view taken along a line XV-XV in FIG. 14. FIG. 16 is a schematic plan view illustrating another aspect of the electronic module 200 according to the first embodiment. FIG. 17 is a schematic cross-sectional view taken along a line XVII-XVII in FIG. 16.

As in the example illustrated in FIGs. 12 and 13, a part of a portion of the casing 210 bonded to the base 2 may be located on the upper surface of the insulation layer 22a on the lower layer side of the first pedestal 22 of the base 2. A front view shape of the casing 210 may be an inverted U-shape. The casing 210 may be bonded to the upper surface of the insulation layer 22a on the lower layer side of the first pedestal 22 of the base 2 by a bonding material such as a brazing material or an adhesive. As in the example illustrated in FIG. 14 and FIG. 15, a side view shape of the casing 210 may be an inverted U-shape.

As in the example illustrated in FIGs. 16 and 17, the electronic module 200 may include a second casing 240 located on the upper surface 21u of the base portion 21 of the base 2 in addition to the casing 210 serving as a first casing located on the upper surface 21u of the base portion 21 of the base 2. The second casing 240 is made of, for example, a metal such as aluminum (Al) or a resin such as polybutylene terephthalate (PBT). The second casing 240 may be bonded to the upper surface 21u of the base portion 21 of the base 2 by a bonding material such as a brazing material or an adhesive. The second casing 240 may cover the upper side of the first element mounting region F1 of the base 2, the upper side of the second element mounting region F2 of the base 2, and the upper side of the first casing 210.

The second casing 240 may include two holding holes 250 and 260 in an upper portion of the second casing 240, and each of the two holding holes 250 and 260 penetrates through the upper portion of the second casing 240. Lenses 270 and 280 may be provided in the two holding holes 250 and 260, respectively, of the second casing 240. The lens 270 may have a function of focusing, diverging, or collimating light emitted from the light emitting element 120. The lens 270 may have a function of focusing external light incident from the outside. Each of the two holding holes 250 and 260 of the second casing 240 may be provided with a member, such as a glass plate, capable of transmitting light instead of the lenses 270 and 280.

### Electronic Element Mounting Substrate and Electronic Device According to Second Embodiment

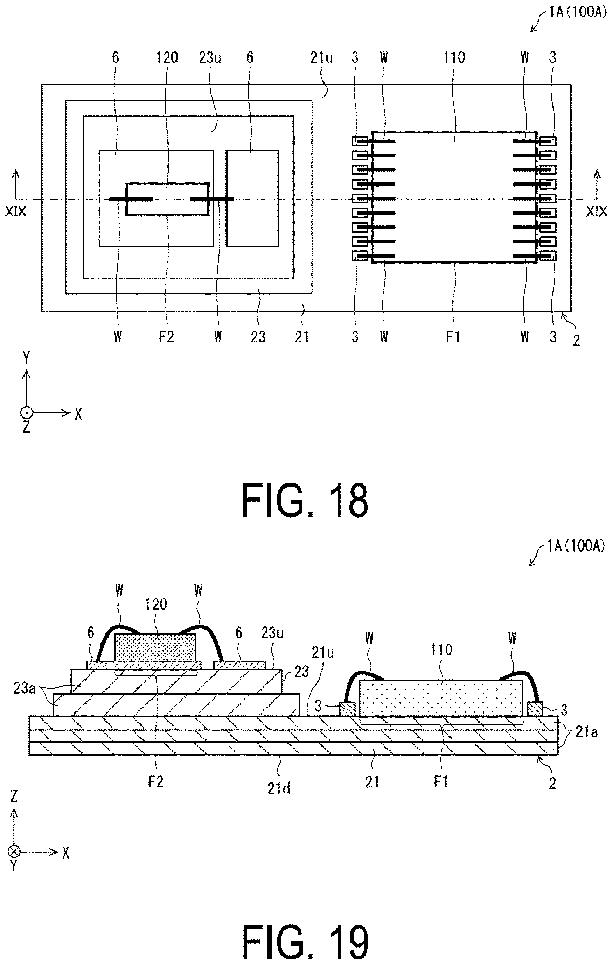

An electronic element mounting substrate 1A and an electronic device 100A according to a second embodiment will be described with reference to FIGs. 18 and 19. FIG. 18 is a schematic plan view illustrating the electronic device 100A according to the second embodiment. FIG. 19 is a schematic cross-sectional view taken along a line XIX-XIX in FIG. 18.

As in the example illustrated in FIGs. 18 to 19, the electronic device 100A includes the electronic element mounting substrate 1A, the light receiving element 110 serving as the first electronic element mounted on the electronic element mounting substrate 1A, and the light emitting element 120 serving as the second electronic element mounted on the electronic element mounting substrate 1A. Except for some configurations, the electronic element mounting substrate 1A according to the second embodiment has the same configuration as that of the electronic element mounting substrate 1 according to the first embodiment. In the configuration of the electronic element mounting substrate 1A according to the second embodiment, differences from the configuration of the electronic element mounting substrate 1 according to the first embodiment will be mainly described. For convenience of description, a member having the same function as that of a member described in the first embodiment is denoted by the same reference sign.

Instead of including the first pedestal 22, the base 2 may include a second pedestal 23 located at a left portion of the upper surface of the base portion 21. The second pedestal 23 is integrated with the base portion 21 and has a second upper surface 23u. The second pedestal 23 may include two insulation layers 23a that have been layered on each other. A plurality of the insulation layers 23a may have the stepped shape in a cross-sectional view. The second pedestal 23 may include a plurality of the insulation layers 23 a other than the two insulation layers 23a that have been layered on each other or one insulation layer 23a.

The first element mounting region F1 for mounting the light receiving element 110 serving as the first electronic element may be located at the right portion of the upper surface 21u of the base portion 21. In other words, the base 2 may have the first element mounting region F1 at the right portion of the upper surface 21u of the base portion 21. The second element mounting region F2 for mounting the light emitting element 120 serving as the second electronic element may be located on the upper surface of the upper insulation layer 23a, which is the second upper surface 23u of the second pedestal 23. In other words, the second upper surface 23u of the second pedestal 23 includes the second element mounting region F2. In still other words, the base 2 may have the second element mounting region F2 on the second upper surface 23u of the second pedestal 23. The first element mounting region F1 and the second element mounting region F2 are parallel to each other and have different heights in a cross-sectional view. The second element mounting region F2 may be higher than the first element mounting region F1 by a thickness of the second pedestal 23 in a cross-sectional view.

The base 2 including the second pedestal 23 is produced by the same method as the base 2 including the first pedestal 22.

As in the example illustrated in FIGs. 18 and 19, according to the configuration of the electronic element mounting substrate 1A according to the second embodiment, the first element mounting region F1 and the second element mounting region F2 are located at different heights in a cross-sectional view. Consequently, the distance between the first element mounting region F1 and the second element mounting region F2 can be increased. A distance from the first element mounting region F1 to the lower surface of the base 2 in contact with the outside is closer than a distance from the second element mounting region F2 to the lower surface. When the heat from the light emitting element 120 propagates, at least a part of the heat is radiated to the outside in contact with the base 2, and thus the influence of the heat on the light receiving element 110 can be reduced. Thus, the heat generated in the light emitting element 120 serving as the second electronic element hardly propagates to the light receiving element 110 side, the light receiving element 110 serving as the first electronic element. Consequently, the likelihood of occurrence of failure of the light receiving element 110 due to the heat generated in the light emitting element 120 can be reduced. In addition, by setting the first element mounting region F1 higher in a cross-sectional view and providing a distance between the first element mounting region F1 and the second element mounting region F2, the electronic device 10A can be reduced in size.

When the second pedestal 23 includes a plurality of insulation layers 23a that have been layered on each other, a large difference in height between the first element mounting region F1 and the second element mounting region F2 in a cross-sectional view can be easily provided by the plurality of insulation layers 23a. The height of the second pedestal 23 can be easily adjusted. Thus, the heat generated in the light emitting element 120 further hardly propagates to the light receiving element 110 side. Consequently, the likelihood of occurrence of failure of the light receiving element 110 due to the heat generated in the light emitting element 120 can be further reduced.

When the plurality of insulation layers 23a have the stepped shape in a cross-sectional view, an installation position of the second connection pad 6 can be adjusted. In that case, the electronic component such as a capacitor can be installed on the upper surface of the insulation layer 23a on the lower layer side in addition to the upper surface of the uppermost insulation layer 23a. Since the second connection pad 6 and the electronic component such as a capacitor can be installed at positions close to each other, the electrical characteristics of the electronic device 100A are improved.

### Electronic Element Mounting Substrate According to Another Aspect of Second Embodiment

The side surfaces of the plurality of insulation layers 23a may be flush with each other in a plan view. In this case, size and weight reduction of the base 2, in other words, size and weight reduction of the electronic element mounting substrate 1A can be achieved. That is, in the contents of the present disclosure, by lengthening a propagation path in the thickness direction instead of lengthening a propagation path between the light emitting element 120 and the light receiving element 110 in the planar direction in order to reduce the propagation of heat, a reduction in the size of the electronic element mounting substrate 1A can be achieved. Making the side surfaces of the insulation layers 23a be flush with each other in a plan view is advantageous for further size reduction of the electronic element mounting substrate 1A.

Two second side surfaces of the second pedestal 23 parallel to the left-right direction (X axis direction) which is the arrangement direction of the first element mounting region F1 and the second element mounting region F2 may be flush with two third side surfaces 21s of the base portion 21 parallel to the left-right direction in a plan view. In this case, the second upper surface 23u of the second pedestal 23 extends in the front-rear direction (Y axis direction). Consequently, a space for installing the casing 210 on the second upper surface 23u of the second pedestal 23 can be secured. In addition, for example, the electronic component such as a capacitor can be installed at the same height as the light emitting element 120 serving as the second electronic element, and the electrical characteristics of the electronic device 100A are improved.

The base 2 may include the first pedestal 22 located at the right portion of the upper surface 21u of the base portion 21. The first element mounting region F1 may be located on the upper surface of the upper insulation layer 22a which is the first upper surface 22u of the first pedestal 22.

### Electronic Element Mounting Substrate and Electronic Device According to Third Embodiment

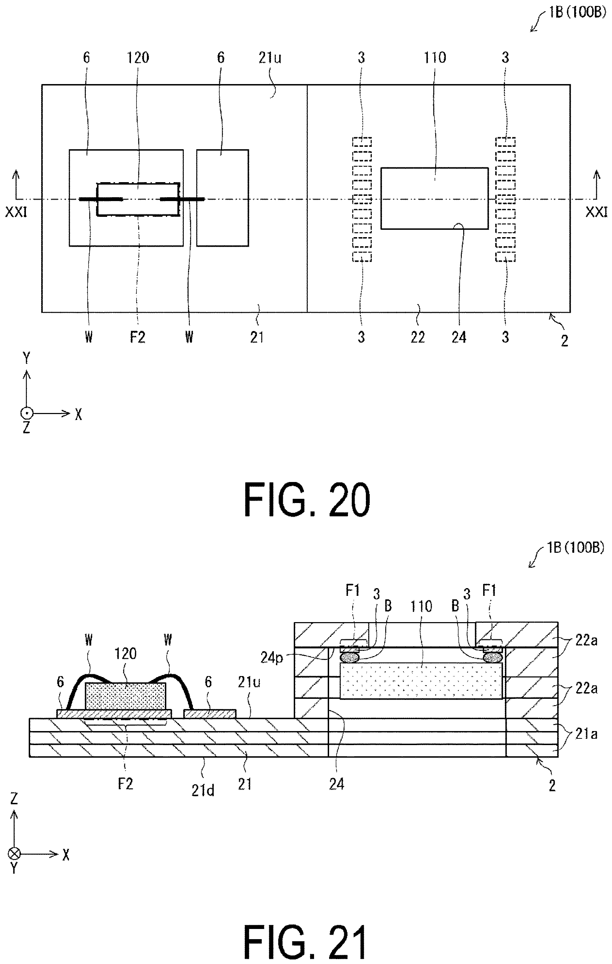

An electronic element mounting substrate 1B and an electronic device 100B according to a third embodiment will be described with reference to FIGs. 20 and 21. FIG. 20 is a schematic plan view illustrating the electronic device 100B according to the third embodiment. FIG. 21 is a schematic cross-sectional view taken along a line XXI-XXI in FIG. 20, and FIG. 21 illustrates only a cross-sectional plane of the electronic device 100B according to the third embodiment.

As in the example illustrated in FIGs. 20 to 21, the electronic device 100B includes the electronic element mounting substrate 1B, the light receiving element 110 serving as the first electronic element mounted on the electronic element mounting substrate 1B, and the light emitting element 120 serving as the second electronic element mounted on the electronic element mounting substrate 1B. Except for some configurations, the electronic element mounting substrate 1B according to the third embodiment has the same configuration as that of the electronic element mounting substrate 1 according to the first embodiment. In the configuration of the electronic element mounting substrate 1B according to the third embodiment, differences from the configuration of the electronic element mounting substrate 1 according to the first embodiment will be mainly described. For convenience of description, a member having the same function as that of a member described in the first embodiment is denoted by the same reference sign.

The base 2 may include a first housing hole 24 with a step for housing the light receiving element 110. The first housing hole 24 may penetrate in the thickness direction of the base 2 from the upper surface of the first pedestal 22 to the lower surface of the base portion 21. A plan view shape of the first housing hole 24 may be a substantially rectangular shape. The first element mounting region F1 for mounting the light receiving element 110 serving as the first electronic element may be located on a stepped surface 24p having a rectangular annular shape of the first housing hole 24. In still other words, the base 2 may have the first element mounting region F1 on the stepped surface 24p of the first housing hole 24.

The first element mounting region F1 may be a region overlapping the stepped surface 24p of the first housing hole 24 in a plan view. The first element mounting region F1 may be a region surrounded by a virtual line connecting alignment marks used when mounting the light receiving element 110. The first element mounting region F1 may be a region where a metalized layer for mounting the light receiving element 110 is located. The first element mounting region F1 and the second element mounting region F2 are parallel to each other and have different heights in a cross-sectional view.

The plurality of first connection pads 3 may be provided on the stepped surface 24p of the first housing hole 24. Each of the plurality of first connection pads 3 may be connected to a corresponding one of the electrodes of the light emitting element 120 serving as the second electronic element by a bump B. In other words, each of the plurality of first connection pads 3 may be connected to a corresponding one of the electrodes of the light receiving element 110 by the flip-chip bonding method. Each of the plurality of first connection pads 3 may be connected to a corresponding one of the electrodes of the light receiving element 110 by the wire bonding method. The stepped surface 24p is a part of the surface of the insulation layer 22a located above the first housing hole 24.

The first housing hole 24 of the base 2 is formed by performing appropriate punching processing on the ceramic green sheet for the insulation layers 21a and 22a before firing the laminate body for the base 2.

As illustrated in the examples in FIGs. 20 and 21, according to the configuration of the electronic element mounting substrate 1B according to the third embodiment, the first element mounting region F1 and the second element mounting region F2 are located at different heights in a cross-sectional view. Consequently, the distance between the first element mounting region F1 and the second element mounting region F2 can be increased. In addition, since the distance from the second element mounting region F2 serving as the heat generating portion to a lower surface of the base 2 in contact with the outside is shorter than the distance from the first element mounting region F1 to the lower surface, heat from the heat generating portion easily propagates from the lower surface of the base 2 to the outside. Thus, the heat generated in the light emitting element 120 serving as the second electronic element hardly propagates to the light receiving element 110 side, the light receiving element 110 serving as the first electronic element. Thus, the likelihood of occurrence of failure of the light receiving element 110 due to the heat generated in the light emitting element 120 can be reduced.

When the stepped surface 24p having the rectangular annular shape of the first housing hole 24 is located in the first element mounting region F1, a contact surface area between the light receiving element 110 and the base portion 21 via the bumps B is reduced, and the heat generated in the light emitting element 120 further hardly propagates to the light receiving element 110 side. Consequently, the likelihood of occurrence of failure of the light receiving element 110 due to the heat generated in the light emitting element 120 can be reduced.

### Electronic Element Mounting Substrate and Electronic Device According to Fourth Embodiment

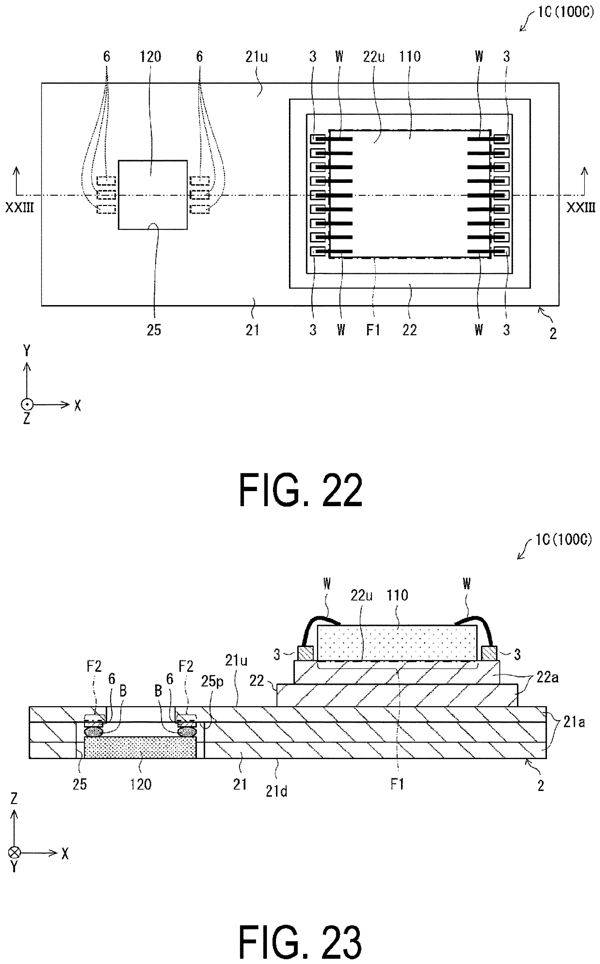

An electronic element mounting substrate 1C and an electronic device 100C according to a fourth embodiment will be described with reference to FIGs. 22 and 23. FIG. 22 is a schematic plan cross-sectional view illustrating the electronic device 100C according to another aspect of the fourth embodiment. FIG. 23 is a schematic cross-sectional view taken along a line XXIII-XXIII in FIG. 22, and FIG. 23 illustrates only a cross-sectional plane of the electronic device 100C according to the fourth embodiment.

As in the example illustrated in FIGs. 22 to 23, the electronic device 100C includes the electronic element mounting substrate 1C, the light receiving element 110 serving as the first electronic element mounted on the electronic element mounting substrate 1C, and the light emitting element 120 serving as the second electronic element mounted on the electronic element mounting substrate 1C. Except for some configurations, the electronic element mounting substrate 1C according to the fourth embodiment has the same configuration as that of the electronic element mounting substrate 1 according to the first embodiment. In the configuration of the electronic element mounting substrate 1C according to the fourth embodiment, differences from the configuration of the electronic element mounting substrate 1 according to the first embodiment will be mainly described. For convenience of description, a member having the same function as that of a member described in the first embodiment is denoted by the same reference sign.

The base 2 may include a second housing hole 25 with a step for housing the light emitting element 120. The second housing hole 25 may penetrate in the thickness direction of the base 2 from the upper surface of the base portion 21 to the lower surface of the base portion 21. A plan view shape of the second housing hole 25 may be a substantially rectangular shape. The second element mounting region F2 for mounting the light emitting element 120 serving as the second electronic element may be located on a stepped surface 25p having a rectangular annular shape of the second housing hole 25. In other words, the base 2 may have the second element mounting region F2 on the stepped surface 25p of the second housing hole 25.

The second element mounting region F2 may be a region overlapping the stepped surface 25p of the second housing hole 25 in a plan view. The second element mounting region F2 may be a region surrounded by a virtual line connecting alignment marks used when mounting the light emitting element 120. The second element mounting region F2 may be a region where a metalized layer for mounting the light emitting element 120 is located. The first element mounting region F1 and the second element mounting region F2 are parallel to each other and have different heights in a cross-sectional view.

The plurality of second connection pads 6 may be provided on the stepped surface 25p of the second housing hole 25. Each of the plurality of second connection pads 6 may be connected to a corresponding one of the electrodes of the light emitting element 120 by the bump B. In other words, each of the plurality of second connection pads 6 may be connected to a corresponding one of the electrodes of the light emitting element 120 by a flip-chip bonding method. Each of the plurality of second connection pads 6 may be connected to a corresponding one of the electrodes of the light emitting element 120 by the wire bonding method. The stepped surface 25p is a part of the surface of the insulation layer 21a located above the second housing hole 25.

The second housing hole 25 of the base 2 is formed by performing appropriate punching processing on the ceramic green sheet for the insulation layers 21a before firing the laminate body for the base 2.

As in the example illustrated in FIGs. 22 and 23, according to the configuration of the electronic element mounting substrate 1C according to the fourth embodiment, the first element mounting region F1 and the second element mounting region F2 are located at different heights in a cross-sectional view. Consequently, a distance between the first element mounting region F1 and the second element mounting region F2 can be increased. Thus, the heat generated in the light emitting element 120 serving as the second electronic element hardly propagates to the light receiving element 110 side, the light receiving element 110 serving as the first electronic element. Thus, the likelihood of occurrence of failure of the light receiving element 110 due to the heat generated in the light emitting element 120 can be reduced.

When the stepped surface 25p having the rectangular annular shape of the second housing hole 25 is located in the second element mounting region F2, a contact surface area between the light emitting element 120 and the base portion 21 via the bumps B is reduced, and the heat generated in the light emitting element 120 further hardly propagates to the light receiving element 110 side. Consequently, the likelihood of occurrence of failure of the light receiving element 110 due to the heat generated in the light emitting element 120 can be further reduced. The light emitting element 120 is housed in the second housing hole 25, which is advantageous in terms of lowering the height of the electronic device 100C.

In the present disclosure, the invention has been described above based on the various drawings and examples. However, the invention according to the present disclosure is not limited to the above-described embodiments. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

1 Electronic element mounting substrate (electronic element mounting substrate according to first embodiment)
2 Base
21 Base portion
21a Insulation layer
21u Upper surface
21d Lower surface
21s Third side surface
22 First pedestal
22u First upper surface
22s First side surface
3 First connection pad
4 First external electrode
5 First wiring conductor
6 Second connection pad
7 Second external electrode
8 Second wiring conductor
9 Thermal via
10 Heat sink
11 Heat shielding portion
100 Electronic Device (electronic device according to first embodiment)
110 Light receiving element (first electronic element)
120 Light emitting element (second electronic element)
200 Electronic module (electronic module according to first embodiment)
210 Casing (first casing)
220 Holding hole
230 Lens
240 Second casing
250 Holding hole
260 Holding hole
270 Lens
280 Lens
F1 First element mounting region
F2 Second element mounting region
1A Electronic element mounting substrate (electronic element mounting substrate according to second embodiment)
23 Second pedestal
23a Insulation layer
23u Second upper surface
1B Electronic element mounting substrate (electronic element mounting substrate according to third embodiment)
24 First housing hole
24p Stepped surface
1C Electronic element mounting substrate (electronic element mounting substrate according to fourth embodiment)
25 Second housing hole
25p Stepped surface

## Claims

1. An electronic element mounting substrate comprising:
a base comprising
a first element mounting region configured to mount a first electronic element, and
a second element mounting region configured to mount a second electronic element, wherein
the first element mounting region and the second element mounting region have different heights in a cross-sectional view.

2. The electronic element mounting substrate according to claim 1, wherein
the base comprises
a base portion comprising an upper surface,
a first pedestal located on the upper surface of the base portion and comprising a first upper surface comprising the first element mounting region and/or a second pedestal located on the upper surface of the base portion and comprising a second upper surface comprising the second element mounting region.

3. The electronic element mounting substrate according to claim 2, wherein
the first pedestal and/or the second pedestal comprises a plurality of insulation layers that have been layered on each other.

4. The electronic element mounting substrate according to claim 3, wherein
surfaces of the plurality of insulation layers are flush with each other in a plan view.

5. The electronic element mounting substrate according to claim 3, wherein
the plurality of insulation layers have a stepped shape in a cross-sectional view.

6. The electronic element mounting substrate according to any one of claims 2 to 5, wherein
a plan view shape of the base portion is a rectangular shape, and a plan view shape of the first pedestal and/or the second pedestal is a rectangular shape, and
two first side surfaces of the first pedestal and/or two second side surfaces of the second pedestal parallel to an arrangement direction of the first element mounting region and the second element mounting region are flush with two third side surfaces of the base parallel to the arrangement direction in a plan view.

7. The electronic element mounting substrate according to claim 1, wherein
the base comprises a first housing hole with a step penetrating along a thickness direction of the base and configured to house the first electronic element, and
the first element mounting region is located on a first stepped surface of the first housing hole.

8. The electronic element mounting substrate according to claim 1 or 2, wherein
the base comprises a second housing hole with a step penetrating along a thickness direction of the base and configured to house the second electronic element, and
the second element mounting region is located on a second stepped surface of the second housing hole.

9. The electronic element mounting substrate according to any one of claims 1 to 6, further comprising:
a heat shielding portion located between the first element mounting region and the second element mounting region in the base and having a coefficient of thermal conductivity lower than that of the base.

10. The electronic element mounting substrate according to any one of claims 1 to 9, further comprising:
a thermal via connected to the first element mounting region and/or the second element mounting region and penetrating along a thickness direction of the base.

11. The electronic element mounting substrate according to any one of claims 1 to 10, further comprising:
a heat sink located on a lower surface of the base and configured to dissipate heat generated from the second electronic element or the first electronic element.

12. An electronic device comprising:
the electronic element mounting substrate according to any one of claims 1 and 7 to 11;
a first electronic element mounted in the first element mounting region; and
a second electronic element mounted in the second element mounting region.

13. An electronic device comprising:
the electronic element mounting substrate according to any one of claims 2 to 6;
a first electronic element mounted in the first element mounting region; and
a second electronic element mounted in the second element mounting region.

14. The electronic device according to claim 12 or 13, wherein
the first electronic element is a light receiving element and the second electronic element is a light emitting element.

15. An electronic module comprising:
the electronic device according to any one of claims 12 to 14; and
a casing located on an upper surface of a base of the electronic device.

16. An electronic module comprising:
the electronic device according to claim 13; and
a casing located on an upper surface of the first pedestal and/or the second pedestal of the electronic device.

17. The electronic module according to claim 16, wherein
the casing comprises
a first casing configured to cover an upper side of the first element mounting region or the second element mounting region, and
a second casing configured to cover both the first element mounting region and the second element mounting region.
